# EUROPEAN PATENT APPLICATION

(11) **EP 0 841 693 A1**
(43) Date of publication of application: **13.05.1998**
(21) Application number: 97118813.1
(22) Date of filing: 29.10.1997
(51) Int. Cl.: H01L 21/8247, H01L 21/8239

(54) **An erasable programmable read only memory and method of manufacture thereof**

(30) Priority: 29.10.1996 US 29087 P
(71) Applicant: TEXAS INSTRUMENTS INCORPORATED, Dallas Texas 75265 (US)
(72) Inventor: Krishnamurthy, Shyam, Irvine, CA 92604 (US); Lahiry, Rana (nmi), Lubbock, TX 79423 (US); Dao, Chris (nmi), Austin, TX 78752 (US); Reddy, Damodar T., Nampally, Nalagonda 57 (IN)
(74) Representative: Schwepfinger, Karl-Heinz, Dipl.-Ing.

(57) **Abstract**

A method for providing electrical isolation between two cells (16) of an EPROM (10 and 58) on a substrate (48) having an outer surface is provided. Such an EPROM preferably has an array (60) containing the cells (16) and a periphery (58). The method includes forming a first conductive layer (64) outwardly from the substrate (40) in the array (60) and periphery (62). The method also includes forming a first insulator layer (66) outwardly from the first conductive layer in the array (6) and periphery (62). Next, the present method includes forming a second conductive layer (68) outwardly from the first insulator layer (66) in the array (60) and periphery (62). The present method includes simultaneously forming a slot (72) in the array (60) through the first conductive (64), first insulator (66), and second conductive layers (68) in the array (60) while removing the first conductive (64), first insulator (66), and second conductive layers (66) from the periphery (62). This invention also includes forming a second insulator layer (73) outwardly from the second conductive layer (68) and in the slot (72) of the array (60) and outwardly from the substrate (90) in the periphery (62). This invention further includes forming a third conductive layer (74) outwardly from the second insulator layer (73) and in the slot (72) of the array (60) and outwardly from the second insulator layer (73) and third conductive layer (74) in the array (60) and periphery (62) while leaving the second insulator (73) and third conductive layers (74) in the slot (72). This present invention also provides for forming a third insulator layer (76) outwardly from the second insulator (79) and third conductive layers (74) in the slot (72) and forming a fourth conductive layer (78) outwardly from the third insulator layer (76) in the slot (72).

## Description

### TECHNICAL FIELD OF THE INVENTION

This invention relates in general to the field of electronic devices, and more particularly to an erasable programmable read only memory (EPROM) and method of manufacture thereof.

### BACK GROUND OF THE INVENTION

The manufacture and use of ultraviolet erasable PROMS (UVEPROMs) and electrically erasable (EEPROMs) is well developed and understood. EPROMs provide a very convenient form of non-volatile memory that can be programmed, erased, and reprogrammed several thousand times. EPROM devices typically include an array section, which contains the memory cells of the device, and a periphery section, which contains the address and driver circuits that are necessary to program and access the memory cells in the array.

A typical EPROM cell is formed form a single metal oxide semiconductor (MOS) transistor on a semiconductor substrate. This transistor usually includes a layer of polysilicon associated with the gate-oxide layer of the transistor. This structure forms a capacitor comprised of the polysilicon layer (first plate), gate-oxide layer (dielectric), and substrate (second plate). The purpose of an EPROM cell is to provide a mechanism for placing charge on or removing charge from the polysilicon layer associated with the gate determines the digital value of the cell, i.e., a "0" or a "1," respectively.

The placement and removal of charge from, the polysilicon layer requires a source of electrical charge be provided in the vicinity of the polysilicon layer. Several techniques have been previously developed to provide such structures. These include the use of two layers of polysilicon as described in U.S. Patent Number 4,342,099, issued to Kuo, entitled *Electrically Erasable* *Programmable MNOS Read Only Memory*, and U.S. Patent Number 4,554,643, issued to Kuo, entitled *Electrically Erasable Programmable MNOS Read-Only Memory*, both of which are assigned to the assignee of the present application.

In a typical EPROM device, the cells within the array are addressed for reading out date and programming using bit-lines and word-lines. The bit and word-lines provide a row and column addressing scheme for accessing and programming the cells in the memory array.

Typically, the bit-line for each cell in the array comprises the drain of each transistor-cell, while a second layer or outer layer of polysilicon (poly 2) forms the word-line to the cell. Each cell may be accessed by activating the appropriate bit and word-line for that cell. The charge is stored in the inner polysilicon layer, i.e., poly 1.

The memory array of an EPROM device will generally include several thousand individual cells. Each cell in the array is separated by a structure known as "plot." The slot provides for isolation between adjacent cells and is particularly important to ensure the reliability of the cells to hold the proper amount charge. The procedure for writing a "0" to a cell is called programming the cell and it involves charging the poly 1. By appropriately biasing the bit-line and the word-line of each cell charge can be injected from the substrate to the poly 1 where the charge remains trapped.

The slot is a region where the poly 1 is removed along the direction of the word-line.

This programming charge has to be retained in this poly layer until it is intentionally removed, i.e., "erased," either electrically or by ultraviolet light. The cell which is in the state "0" is called the programmed cell.

Among the many mechanisms by means of which the charge on a programmed cell can be lost is the mechanism called word-line stress down which occurs in a non-volatile memory device when the cells sharing the same word-line as an already programmed cell is attempted to be programmed. This loss is usually due to a bad insulating layer between the ploy 1 and poly 2. The insulator is also called the inter-level dielectric.

The programming charge on a cell may "leak" over time, particularly when an adjacent cell sharing the same wordline is being programmed.

One previously developed method for testing the reliability of a memory cell is the word-line stress test which tests for word-line stress down.

The tendency is, however, for an already programmed cell to loss charge during the word-line stress test. To diminish this effect and increase the reliability of the cells in the array, it is necessary to exchange the reliability between the poly 1 and poly 2 layer over all the region where they overlap with each other. This includes the region of the slot where sufficient insulation is needed between the poly 1 and poly 2 at the slot sidewall areas.

One acceptable prior approach to such isolation involves placing an oxide-to-nitride-to-oxide (ONO) structure in the slot between adjacent cells. The nitride in the ONO structure prevents charge from the poly 1 from migrating the poly 2 in large quantities such as to cause the data (0'') to be lost due to the stringent reliability requirement of isolating the two poly layers.

Unfortunately, previously developed methods for forming an acceptable slot structure between adjacent cells in a memory array require that the first polysilicon layer (poly 1) in the array and periphery be formed at different mask levels. Each mask level has associated with it several processing steps including coating the wafer, patterning the wafer, exposing the wafer, and developing the coating on the wafer using photolithographic equipment. The photolithography equipment used in the masking process is typically the most expensive equipment used in building semiconductors so the amount of this equipment in a semiconductor "front-end" is generally minimized. This, in turn, may create a bottleneck for the necessary photolithographic processing which adds both time and expense to the manufacture of an EPROM.

Faced with ever increasing demands for higher yield, at lower costs, with quicker turn around times, these additional processing steps required to build a reliable EPROM cell may be unacceptable for impractical.

### SUMMARY OF THE INVENTION

Therefore, a need has arisen for an EPROM device and method of manufacture that minimizes manufacturing processing steps while providing a reliable device.

In accordance with the present invention, an EPROM and method of manufacture are provided that substantially eliminate and reduce disadvantages and problems associated with previous systems and methods for building EPROM cells and methods of manufacture.

One aspect of the present invention provides a method for providing electrical isolation between poly 1 and poly 2 in the slot area-especially in the poly 1 sidewall area in the slot which is created when poly 1 is etched away between two cells showing the same word-line of an EPROM on a substrate having an outer surface. Such an EPROM preferably has an array containing the cells and a periphery. The method includes forming a first conductive layer outwardly from the substrate in the array and periphery. The method also includes forming a first insulator layer outwardly from the first conductive buyer in the array and periphery. Next, the present method includes forming a second conductive layer outwardly from the first insulator layer in the array and periphery.

The present method includes simultaneously forming a slot in the array through the first conductive first insulator, and second conductive layers in the array while removing the first conductive, first insulator, and second conductive layers from the periphery. This invention also includes forming a second insulator layer outwardly from the second conductive layer and in the slot of the array and outwardly from the substrate in the periphery. This invention further includes forming a third conductive layer outwardly from the second insulator layer and in the slot of the array and outwardly from the second insulator layer in the periphery. The present invention further includes removing the second insulator layer and third conductive layers in the array and periphery while leaving the second insulator and third conductive layers in the slot. This aspect of the invention also includes forming a third insulator layer outwardly from the second insulator and third conductive layer in the slot and forming a fourth conductive layer outwardly from the third insulator layer in she slot.

Another aspect of the present invention provides a method for forming an EPROM having an array containing memory cells and a periphery on a substrate having an outer service. This aspect of the present invention includes forming a first conductive layer outwardly from the substrate in the array and periphery. The method also includes forming a first insulator layer outwardly from the first conductive layer in the array and periphery. Next, the present method includes forming a second conductive layer outwardly from the first insulator layer in the array and periphery. The present method includes simultaneously forming a slot in the array through the first conductive, first insulator, and second conductive layers in the array while removing the first conductive first insulator, and second conductive layers from the periphery. This invention also includes forming a second insulator layer outwardly from the second conductive layer and in the slot of the array and outwardly from the substrate in the periphery. This invention further includes forming a third conductive layer outwardly from the second insulator layer and in the slot of the array and outwardly from the second insulator layer in the periphery.

The present invention further includes removing the second insulator layer and third conductive layer in the array and periphery while leaving the second insulator and third conductive layer in the slot. This aspect of the invention also includes forming a third insulator layer outwardly from the second insulator and third conductive layer in the slot and forming a fourth conductive layer outwardly from the third insulator layer in the slot. Forming the source and drain for each cell in the array and forming the circuitry of the array are also parts of the present invention.

The present invention provides several technical advantages. One important technical advantage of the present invention is that it provides a method for manufacturing an EPROM device while eliminating a mask level during the manufacturing process. This reduces the photolithography processing required to make the EPROM device. This mask level reduction also reduces the time and expense necessary to manufacture an EPROM in accordance with the present invention.

Another technical advantage of the present EPROM is that it provides a reliable EPROM that is not susceptible to charge loss. The present EPROM achieves this capability with a superior slot structure between adjacent cells within the memory array.

Yet another technical advantage of the present invention is that it is suitable for use with both UVEPROMS and EEPROMS.

### BRIEF DESCRIPTION OF THE DRAWINGS

For a more complete understanding of the present invention and advantages thereof, reference is now made to the following description taken in conjunction with accompanying drawings, in which like reference numbers indicate like features and wherein:
FIGURE 1 is a plan view of an exemplary EPROM cell manufactured in accordance with the present invention;
FIGURE 2A and 2B illustrate in cross-section the manufacture of the slot structure between adjacent cells in an EPROM in accordance with prior art techniques;
FIGUREs 3A through 3E illustrate in cross-section the formation of an EPROM cell embodying concepts of the present invention.

### DETAILED DESCRIPTION OF THE INVENTION

Preferred embodiments of the present invention are illustrated in the FIGUREs, like numerals being used to refer to like and corresponding parts of the various drawings.

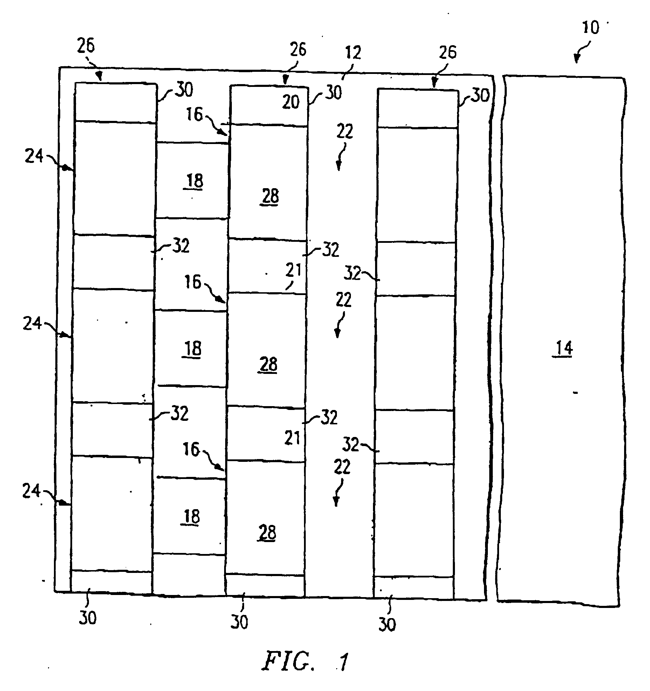

FIGURE 1 shows a plan view of EPROM device 10, which includes memory array 12 and periphery 14. Array 12 typically includes multiple memory cells 16. Each cell in array 12 is a transistor having drain region 18, gate region 20, and a source region 22. Array 12 is organized into rows 24 and columns 26. Each cell 16 has a separate drain 18, but typically the source 22 of each cell in a particular column 26 is formed of a continuous source region. Gate 20 of each cell 16 is underneath polysilicon layer 28, sometimes referred to as the first polysilicon (poly 1). The second polysilicon layer (poly 2) 30 covers gate 20 and poly 1 28 of each cell 16 in each column 26. In the portion of device 10 shown in FIGURE 1, poly 2 30 is the word-line and source diffusion 22 is the bit-line for each cell 16. Periphery 14 contains the necessary circuitry (not explicitly shown) to address and program and erase the cells in array 12. It is noted that only a portion of array 12 and periphery 14 of device 10 is shown in FIGURE 1. A typical EPROM device may contain over one million cells 16 in array 12.

Separating poly 1 28 for each cell 16 in each column 26 is slot 32. As previously described, slot 32 provides electrical isolation between adjacent cells in each column 26. Each cell 16 within array 12 may be accessed by applying appropriate charge levels to poly 2 30 and drain diffusion 18. Slot 32 provides electrical isolation between adjacent cells so that the programming or addressing of a particular cell within a given column 26 does not affect the charge stored in cells adjacent to the addressed cell.

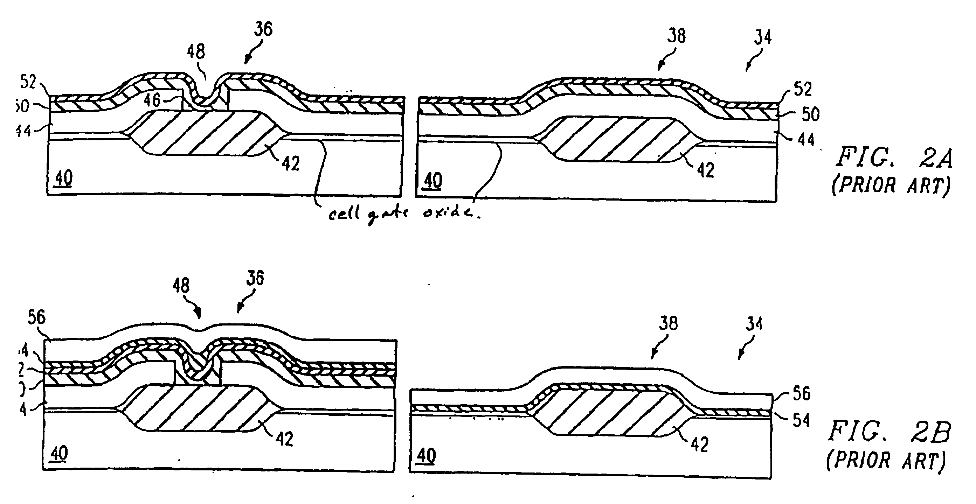

FIGURE 2A illustrates a previously developed method for manufacturing a reliable slot structure between adjacent cells in the array of an EPROM. EPROM device 34 in FIGURE 2A includes array 36 and periphery 38. The starting point of device 34 is substrate 40. Substrate 40 is, for example, a wafer of P-type monocrystalline silicon typically 8 inches in diameter and 20 mils thick, but on the (100) plane, and of a resistivity of about 14 ohm-cm. The portion of semiconductor subsrate 40 shown in FIGURE 2A is only a very small part of substrate 40.

After appropriate cleaning of the surface of substrate 40, field oxide (FOX) layer 42 is formed in appropriate locations in array 36 and periphery 38 of device 34. Field oxide provides isolation between cells. Typically, FOX layer 42 is grown outwardly from the surface of substrate 40, patterned, and etched to the desired configuration. Once FOX layer 42 is formed in array 36 and periphery 38, and an appropriate cell gate oxide is formed over the substrate, poly 1 layer 44 is deposited outwardly from the surface of the gate oxide and field oxide 42 in both array 36 and periphery 38. Cell gate oxide is usually 90-300A thick and grown thermally. Poly 1 44 is typically of the order of 1500 to 2,000A thick with a high sheet resistance on the order of, for example, 2K to 5K per square. Poly 1 44 may be deposited outwardly from cell gate oxide and field oxide 42. The electrical characteristics of poly 1 layer 44 may be modified by appropriate doping of poly 1 layer 44. Both diffusion doping (POCL) and ion implantation doping are suitable for doping poly 1 layer 44. The deposition of poly 1 44 may occur at, for example, 650°C with the doping of poly 1 44 occurring at 850 to 950°C. Alternatively, the doping of poly 1 44 incur *in sit, i.e*., poly 1 44 may be doped as it is formed.

Once poly 1 44 is formed, opening 46 is formed in slot 48 of array 36 in poly 1 44. Slot 48 will be used to form an appropriate electrical isolation structure between adjacent cells in array 36. Opening 46 may be formed using appropriate masking and etching techniques so as to remove poly 1 44 to expose FOX layer 42 in array 36 of device 34. Through appropriate masking of periphery 38, poly 1 44 in periphery 38 of device 34 is not effected by the etching of slot 48 in Poly 1 44 of array 36.

Next, oxide layer 50 is formed outwardly from poly 1 44 in array 36 and periphery 38 and in opening 46 of poly 1 44. Oxide layer 50 is typically referred to as an interlevel oxidation (ILO) layer and is typically grown or deposited outwardly from poly 1 44 in both array 36 and periphery 38 of device 34. The thickness of ILO layer 50 is typically of the order of 50-150A. Next, an interlevel nitride (ILN) layer 52 is formed outwardly from ILO layer 50 in both array 36 and periphery 38. ILN layer 52 is typically formed by depositing Si₃N₄ outwardly from ILO layer 50 to a thickness of approximately 50-150A. It is noted that other materials other than nitride may be used to form ILN layer 52 to provide a suitable layer for trapping charge.

Next, ILN layer 52 may be steam sealed at high temperature to reduce pin-holes within layer 52 and to grow a certain amount of thermal oxide on the surface of ILN layer 52. Steam sealing of ILN layer 52 occurs in both array 36 and periphery 38. The purpose of steam sealing layer 52 is to increase the reliability of the cells in array 36 of device 34. Once ILN layer 52 is steam sealed the resulting structure in both array 36 and periphery 38 is shown in FIGURE 2A.

The next step in the formulation of prior art device 34 in FIGUREs 2A and 2B is the removal of poly 1 layer 44 in periphery 38. In order to accomplish this while leaving the structure formed in array 36 as shown in FIGURE 2A, all of array 36 is covered with a suitable protective coating so that it is not affected by the etching of poly 1 layer 44 in periphery 38. Once array 36 is covered with a suitable photoresist, then ILN layer 52, ILO layer 50, and poly 1 layer 44 are removed from periphery 38. Because poly 1 layer 44 are masked and etched in separate steps for the array and periphery in this prior art system, an additional mask level is required. This adds significant costs to the processing of the prior art device 34 as well as additional time. The goal of the present invention is, therefore, to form poly 1 layer 44 in both array 36 and periphery 38 using a single mask level to reduce the mask levels and achieve the inherent cost and time savings attendant with the elimination of a mask level.

Returning to FIGURE 2B, once poly 1 layer 44, ILO layer 50, and ILN layer 52 are removed from periphery 38 of device 34, an HF oxide dip may be used to remove the HF acid remaining oxide from periphery 38. Next, all remaining photoresist on device 34 is removed from array 36 and periphery 38. Next, CMOS oxide growth layer 54 is formed outwardly from ILN layer 52 in array 36 and outwardly from substrate 40 and field oxide 42 in periphery 38. Next, polysilicon layer 2 or poly 2 56 is formed outwardly from CMOS oxide layer 54 in both array 36 and periphery 38.

The resulting structure shown in FIGURE 2B provides slot 48 in array 36 in which an ONO (oxide-nitride-oxide) structure exist along the sidewalls of slot 48. This slot structure provides enhanced isolation between the cells in array 36. Unfortunately, the formation of this reliable ONO structure requires that poly 1 layer 44 be separately formed in array 36 and periphery 34 as previously described.

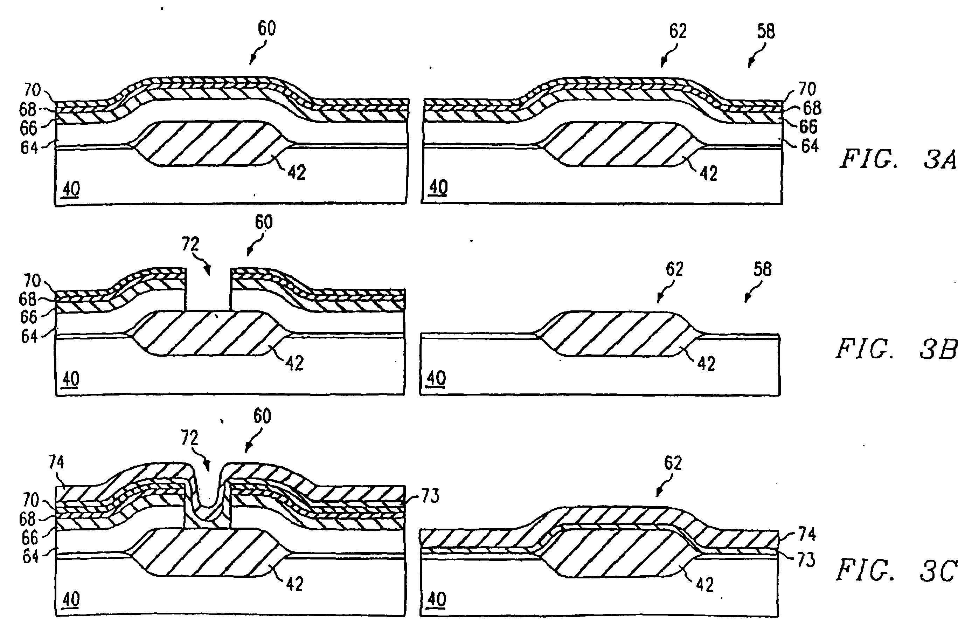

FIGUREs 3A through 3E illustrate improved EPROM cell 58 and method of manufacture in accordance, with present invention. Device 58 in FIGURE 3A includes array section 60 and periphery section 62. The initial step in the formation of device 58 is the deposition or growth of first conductive layer or ply 1 layer 64 outwardly from the surface from substrate 40 and field oxide 42, similarly to the formation of poly 1 layer 44 in device 34. Next, first insulator layer or ILO layer 66 is formed outwardly from the surface of ply 1 64 in both array 60 and periphery 62 of device 58. ILO layer 66 is formed in a similar manner as ILO layer 50 described above. Next, second conductive layer or ILN layer 68 is formed outwardly from the surface of ILO layer 66 in both array 60 and periphery 62 of device 58, similarly to the formation of ILN layer 52 described above. Next, second conductive layer or ILN layer 68 may be steam sealed as described above for ILN layer 52 forming ILNO (interlevel-nitride-oxide) layer 70 in both array 60 and periphery 62 of device 58. Once ILNO layer 70 is formed, array 60 and periphery 62 of device 58 are as shown in FIGURE 3A.

Now slot 72 within array 60 of device 58 may be formed. In accordance with the present invention, slot 72, which necessarily includes the etching of poly 1 layer 64 in array 60 occurs simultaneously with the etching of poly 1 layer 64 in periphery 68. This allows poly 1 layer 64 to be formed in both array 60 and periphery 62 with a single mask level. This eliminates the requirement in prior art device 34 of FIGUREs 2A and 2B to separately form additional mask level for poly 1 layer 44.

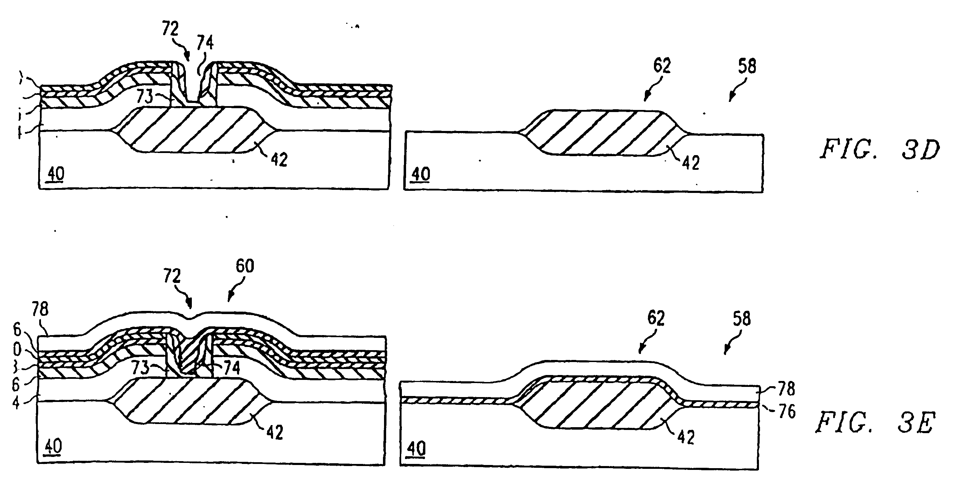

Slot 72 in array 60 is formed by appropriate masking and etching of ILNO layer 68, ILN layer 70, ILO layer 66, and poly 1 layer 66. This etching of the layers within array 60 also occurs with the clearing of periphery 62 down to substrate 40 and field oxide 42. The resulting structure is shown in FIGURE 3B. With the etching of poly 1 layer 64 in both array 60 and periphery 62 accomplished with a single step, a mask level is eliminated and the remainder of the formation of slot 72 may be accomplished.

Proceeding to FIGURE 3C, second insulator layer or oxide layer 73 is formed outwardly from ILNO layer 70 and in slot 72 of array 60 and outwardly from substrate 40 and FOX layer 42 in periphery 62. Oxide layer 73 may be on the order of 300A thick and formed using a silian (SiH₄) based chemical vapor deposition (CVD) oxide deposition over the entire surface of array 60 and periphery 62 of device 58. Next, third conductive layer or nitride layer 74 is formed outwardly from oxide layer 73 and within slot 72 of array 60 and outwardly from oxide layer 73 in periphery 62. The resulting structures for array 60 and periphery 62 are shown in FIGURE 3C with oxide layer 73 and nitride layer 74 formed in slot 72 of array 60 in device 58.

Next, an etch to create nitride-oxide sidewalls within slot 72 is accomplished. In one embodiment of the present invention, an anisotropic etch creates nitride sidewalls within slot 72. The anisotropic etch etches only vertically leaving the desired oxide-nitride structure within slot 72. Oxide layer 72 in periphery 62 protects the periphery during the anisotropic etch. Next, the remaining oxide on the surface of array 60 and periphery 62 is remove using, for example, and HF dip, resulting in array 60 and periphery 62 of device 58 as shown in FIGURE 3D.

Turning to FIGURE 3E, next, third insulator layer or CMOS gate layer 76 is grown outwardly from ILNO layer 70 and in slot 72 of array 60 and outwardly from the surface of substrate 40 and FOX layer 42 in periphery 62. A fourth conductive layer or second polysilicon layer (poly 2) 78 is formed outwardly from CMOS gate layer 76 and in slot 72 of array 60 and outwardly from CMOS gate layer 76 in array 62 providing the resulting structure shown in FIGURE 3E.

In a variant of this process and especially in order to retain a thick top oxide for the ONO inter-poly dielectric which may get etched away prior to periphery CMOS gate layer growth during the HF dip, the CMOS oxide may be grown using a stacked oxide technique described in D. Shum, et al. IEEE trans on electron devices Vol. 42, No. 7, July 1995. Using this method, a 30-50A oxide layer may be deposited after the HF dip using LPVCD or other high quality oxide deposition techniques. The wafer may then be subjected to sufficient oxidation to grow the desired oxide to form the gate oxide in the periphery devices. This improves the reliability of the cell so formed without degrading the reliability of the periphery CMOS oxide considerably. It is especially useful in a duel gate (periphery devices which have thinner and thicker gate oxides) process/technology, as the reliability on the thicker oxide is not as stringent as the thinner oxide and the thinner oxide is grown using a thermal oxide in any case.

Similar to prior art FIGURE 2B, slot 72 in array 60 of device 58 in FIGURE 3E has the reliable ONO structure within slot 72 while eliminating the mask level rehired to etch poly 1 layer 64 in periphery 62 of device 58. The present method adds three steps; CVD oxide formation, nitride deposition, and nitride etch, while removing a mask level step. The present EPROM cell 58 therefore may be manufactured in less time and for less money than the prior art EPROM cell 34 shown I FIGUREs 2A and 2B.
Additionally, the remainder of EPROM 58 may be formed in the following steps. Once the slot is formed and the ply 2 is deposited, the poly 2 in the periphery is etched to define the periphery transistors, i.e., the periphery CMOS gate region is patterned and the poly 2 is etched away in the source/drain regions of the transistors, as well as in areas separating the transistors. After the poly 2 is patterned in the periphery, the poly 2 in the array is patterned to define the word line. After this pattern, the poly 2/ONO/poly 1 stack is etched over the source/drain areas, which are not yet formed at this point, to expose the substrate in these areas. Another pattern over the source area can sometimes be used in order to remove the field oxide in the region between two cells in the direction parallel to the word-line in order to form a continuous source-line and also to implant N-type species such as arsenic and phosphorous into the source areas to form the source diffusion. Prior to the formation of the slot or the deposition of the poly 1, a thin, high-quality oxide is grown over the substrate which may have been implanted with P-type dopant to set the threshold voltage of the individual cells.

The source implant may be followed by a diffusion/anneal/oxidation to activate/diffuse the dopants. Subsequent to that, another pattern is used to ion implant the drain. For some EEPROMS, the, source and drain diffusions are asumetric, i.e. require different patterns and levels of implant dose and subsequent anneal. In symmetric source/drain EPROMs, the source and drain are created using a single pattern. Subsequent to creation of these diffusions, additional patterns create the periphery CMOS source ad drains. The array/periphery source and drains are then contacted and all the drains in a bit-line (in rows perpendicular to the word-line) are joined with a metal layer. Prior to metalization and contact formation, a thick layer of dielectric is deposited and usually planarized, and the contact is formed after patterning the contact areas and etching this dielectric in the contact areas through to the substrate. The metal layer is then patterned to connect up different individual transistors and devices to form the integrated circuit.

The present invention provides an EPROM that may be formed while eliminating a mask level step in the formation of the first polysilicon layer in both the array and the periphery. The elimination of a mask level reduces the costs and time needed for formation of the present EPROM cell while not affecting its reliability.

Although the present invention has been described in detail, it should be understood that various changes, substitutions, and alterations can be made hereto without departing from the spirit and scope of the invention.

## Claims

1. A method for providing electrical isolation between cells of an EPROM having an array containing the cells and a periphery, the method comprising the steps of:
forming a first conductive layer outwardly from a substrate in the region of the array and periphery;
forming a first insulator layer outwardly from the first conductive layer;
forming a second conductive layer outwardly from the first insulator layer;
simultaneously forming a slot in the array through the first conductive, first insulator, and second conductive layers while substantially removing the first conductive, first insulator, and second conductive layers from the periphery;
forming a second insulator layer outwardly from the second conductive layer and in the slot of the array and outwardly from the substrate in the periphery;
forming a third conductive layer outwardly from the second conductive layer and in the slot of the array and outwardly from the substrate in the periphery;
forming a third conductive layer outwardly from the second insulator layer and in the slot of the array and outwardly from the second insulator layer in the periphery;
substantially removing the second insulator layer and third conductive layer in the region of the array and region of the periphery while leaving the second insulator and third conductive layers in the slot;
forming a third insulator layer outwardly from the third conductive layer in the slot; and
forming a fourth conductive layer outwardly from the third insulator layer in the slot.

2. The method of Claim 1, further comprising forming the first conductive layer from polysilicon.

3. The method of Claim 1 or Claim 2, further comprising forming the insulator from an oxide.

4. The method of any of Claims 1 to 3, further comprising forming the second conductive layer from a nitride.

5. The method of any preceding Claim, wherein the step of simultaneously forming the slot further comprises etching the first conductive, first insulator, and second conductive layer in the array while removing the first conductive, first insulator, and second conductive layers from the region of the periphery.

6. The method of any preceding Claim, further comprising forming the second insulator layer from an oxide.

7. The method of any preceding Claim, further comprising forming the third conductor layer from a nitride.

8. The method of any preceding Claim, wherein the removing step further comprises anisotropicaly etching the second insulator layer and third conductive layer so as to leave these layers in the slot while substantially removing these layers from the remainder of the array.

9. The method of any preceding Claim, further comprising forming the third insulator from an oxide.

10. The method of any preceding Claim, further comprising forming the fourth conductive layer from polysilicon.

11. The method of any preceding Claim, further comprising the step of steam-sealing the second conductive layer prior to the simultaneously forming step.

12. A method for forming an EPROM having an array containing memory cells and a periphery on a substrate, the method comprising the steps of:
forming a first conductive later outwardly from the substrate in the region of the array and periphery;
forming a first insulator layer outwardly from the first conductive layer;
forming a second conductive layer outwardly from the first insulator layer;
simultaneously forming a slot in the array through the first conductive, first insulator, and second conductive layers from the periphery;
forming a second insulator layer outwardly from the second conductive later and in the slot of the array and outwardly from the substrate in the periphery;
forming a third conductive later outwardly from the second insulator layer and in the slot of the array and outwardly from the second insulator layer in the periphery;
substantially removing the second insulator layer and third conductive layer in the array and periphery while leaving the second insulator and third conductive layers in the slot;
forming a third insulator layer outwardly from the third conductive layer in the slot; and
forming the source and drain for each cell in the array.

13. The method of Claim 12, further comprising forming the first conductive layer from polysilicon.

14. The method of Claim 12 or Claim 13, further comprising forming the first insulator from an oxide.

15. The method of any of Claims 12 to 14, further comprising forming the second conductive layer from a nitride.

16. The method of any of Claims 12 to 15 wherein the simultaneously forming step further comprises etching the first conductive, first insulator, and second conductive layer in the array while removing the first conductive, first insulator, and second conductive layer from the periphery.

17. The method of any of Claims 12 to 16, further comprising forming insulator layer from an oxide.

18. The method of any of Claims 12 to 17, further comprising forming conductor later from a nitride.

19. The method of any of Claims 12 to 18, wnerein the removing step further comprises anisotropically etching the second insulator layer and third conductive layer so as to leave these layers in the slot while removing these layers from the remainder of the array.

20. The method of any of Claims 12 to 19, further comprising forming insulator from an oxide.

21. The method of any of Claims 12 to 20, further comprising forming conductive layer from polysilicon.

22. The method of any of Claims 12 to 21, further comprising the step of steam-sealing the second conductive layer prior to the simultaneously forming step.
